# EUROPEAN PATENT APPLICATION

(11) **EP 2 073 031 A2**
(43) Date of publication of application: **24.06.2009**
(21) Application number: 08171862.9
(22) Date of filing: 16.12.2008
(51) Int. Cl.: G01R 31/36, H01M 10/48, G01R 31/02

(54) **Battery pack, portable device, internal short detecting method, and internal short detecting program**

(30) Priority: 18.12.2007 JP 2007326459; 12.06.2008 JP 2008154519
(71) Applicant: Mitsumi Electric Co., Ltd., Tama-shi, Tokyo 206-8567 (JP)
(72) Inventor: Ikeuchi, Akira, Tokyo 206-8567 (JP); Majima, Yoshihide, Tokyo 206-8567 (JP); Nakano, Itsuki, Tokyo 206-8567 (JP); Kasai, Kenichi, Tokyo 206-8567 (JP)
(74) Representative: Vinsome, Rex Martin

(57) **Abstract**

In a battery pack including a battery unit containing a plurality of secondary batteries, an occurrence of an internal short-circuit in the battery unit is detected based on a difference between a first voltage of the battery unit detected at a time a current flowing in the battery unit is below a predetermined current value and a second voltage of the battery unit detected at a time after a predetermined period has elapsed while the current flowing in the battery unit is below the predetermined current value.

## Description

### BACKGROUND OF THE INVENTION

### 1. Field of the Invention

This invention relates to a battery pack which detects an internal short-circuit in a battery unit contained in the battery pack, a portable device including a battery pack, an internal short detecting method for detecting an internal short-circuit in a battery pack, and an internal short detection program.

### 2. Description of the Related Art

In recent years, a portable device, such as a digital camera, carries a battery unit in which two or more lithium ion batteries as secondary batteries are connected together. Because lithium ion batteries are prone to overcharging or overdischarging, the lithium ion batteries are arranged with a battery pack containing a protection circuit for protecting the batteries from overcharging or overdischarging.

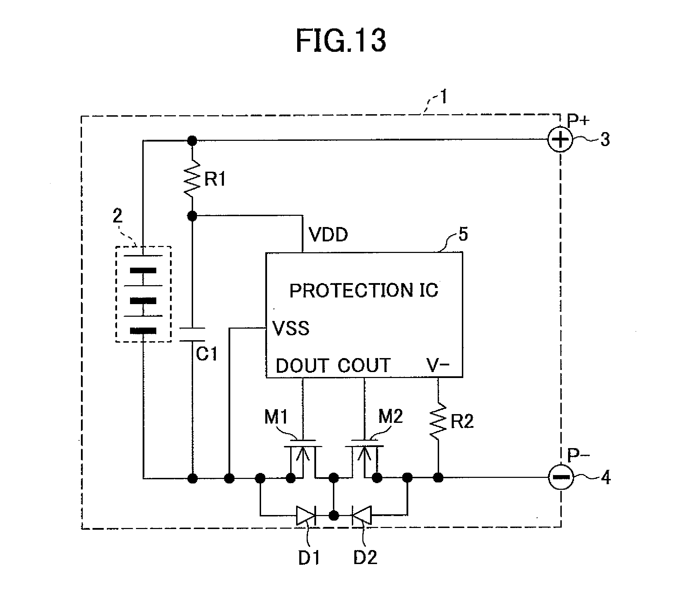

FIG. 13 shows the composition of a battery pack 1 according to the related art. In the battery pack 1 of FIG. 13, a battery unit 2 in which a plurality of lithium ion batteries are connected together is connected in parallel with a series circuit in which a capacitor Cl and a resistor R1 are connected in series. A positive electrode of the battery unit 2 is connected to an external terminal 3 of the battery pack 1, and a negative electrode of the battery unit 2 is connected to an external terminal 4 of the battery pack 1 via a pair of n channel MOS (metal oxide semiconductor) transistors M1 and M2 for current interception.

The drains of the MOS transistors M1 and M2 are connected to each other, the source of the MOS transistor M1 is connected to the negative electrode of the battery unit 2, and the source of the MOS transistor M2 is connected to the external terminal 4. Body diodes D1 and D2 are connected between the drain and the source of each of the MOS transistors M1 and M2 respectively in an equivalent manner.

A protection IC (integrated circuit) 5 is arranged in the battery pack 1 so that the protection IC 5 includes an overcharge detecting circuit, an overdischarge detecting circuit, and an overcurrent detecting circuit. A power-source voltage Vdd is supplied to the protection IC 5 through the resistor R1 from the positive electrode of the battery unit 2, and a power-source voltage Vss is supplied to the protection IC 5 from the negative electrode of the battery unit 2, so that the protection IC 5 operates.

When an overdischarge or overcurrent is detected by the overdischarge detecting circuit or the overcurrent detecting circuit, the protection IC 5 sets the output signal DOUT to the low level to turn the MOS transistor M1 to an OFF state. When an overcharge is detected by the overcharge detecting circuit, the protection IC 5 sets the output signal COUT to the low level to turn the MOS transistor M2 to the OFF state.

The battery pack of the above type may be arranged to have additional functions, including a function of detecting the battery remaining quantity of the battery unit, and a function of detecting whether the lithium ion batteries contained in the battery unit are the standard products. For example, Japanese Laid-Open Patent Application No. 2006-92850 discloses a battery pack which carries a protection module provided with a function of detecting battery chargers supplied from non-authorized parties.

However, the above-described battery pack according to the related art does not have a function of protecting the batteries from short-circuit which may take place in the battery unit. Even if the above battery pack can protect the lithium ion batteries from overcharging and overdischarging, it is difficult to secure safety when short-circuit takes place in the battery unit. Therefore, when an internal short-circuit occurs in the battery unit due to a manufacturing defect, due to a deposition of metal lithium through overdischarging of the batteries, or due to mechanical impact or stress of the batteries, the above-described battery pack according to the related art may involve a risk of resulting in an accident, such as an explosion or a burst.

### SUMMARY OF THE INVENTION

In one aspect of the invention, the present disclosure provides an improved battery pack in which the above-described problems are eliminated.

In one aspect of the invention, the present disclosure provides a battery pack which is able to secure safety when a short-circuit takes place inside a battery unit containing a plurality of secondary batteries.

In an embodiment of the invention which solves or reduces one or more of the above-mentioned problems, the present disclosure provides a battery pack including a battery unit containing a plurality of chargeable and dischargeable secondary batteries, the battery pack comprising: a current detecting unit configured to detect a current which flows in the battery unit; a voltage detecting unit configured to detect a voltage of the battery unit; and a short detecting unit configured to detect an internal short-circuit in the battery unit, wherein the short detecting unit is configured to determine that an internal short-circuit in the battery unit occurs, when a difference between a first voltage of the battery unit detected at a time a current flowing in the battery unit is below a predetermined current value and a second voltage of the battery unit detected at a time after a predetermined period has elapsed while the current flowing in the battery unit is below the predetermined current value is larger than a predetermined voltage difference value.

The above-mentioned battery pack may be arranged to further comprise a capacity value acquiring unit configured to acquire an available capacity value of the battery unit, based on a voltage detected by the voltage detecting unit, wherein the short detecting unit is configured to determine that an internal short-circuit in the battery unit occurs, when a difference between a first available capacity value of the battery unit acquired at a time a current flowing in the battery unit is below the predetermined current value and a second available capacity value of the battery unit acquired at a time after a predetermined period has elapsed while the current flowing in the battery unit is below the predetermined current value is larger than a predetermined value.

The above-mentioned battery pack may be arranged to further comprise: a temperature detecting unit configured to detect a temperature of the battery unit; and a temperature compensation unit configured to correct a voltage detected by the voltage detecting unit based on a temperature detected by the temperature detecting unit, wherein the capacity value acquiring unit is configured to acquire an available capacity value of the battery unit based on the voltage corrected by the temperature compensation unit.

The above-mentioned battery pack may be arranged to further comprise a current value computing unit configured to compute a value of a current consumed during a predetermined period, based on a difference between a first available capacity value of the battery unit acquired at a time a current flowing in the battery unit is below the predetermined current value and a second available capacity value of the battery unit acquired at a time after the predetermined period has elapsed while the current flowing in the battery unit is below the predetermined current value, wherein the short detecting unit is configured to determine that an internal short-circuit in the battery unit occurs, when the value of the current computed by the current value computing unit is larger than a reference value.

The above-mentioned battery pack may be arranged to further comprise a communication unit configured to communicate with a portable device in which the battery pack is arranged, wherein the communication unit outputs a notice of internal short detection to the portable device when it is determined by the short detecting unit that an internal short-circuit in the battery unit occurs.

In an embodiment of the invention which solves or reduces one or more of the above-mentioned problems, the present disclosure provides a portable device in which a battery pack is arranged, the battery pack including a battery unit containing a plurality of chargeable and dischargeable secondary batteries, the battery pack comprising: a current detecting unit configured to detect a current which flows in the battery unit; a voltage detecting unit configured to detect a voltage of the battery unit; and a short detecting unit configured to detect an internal short-circuit in the battery unit, wherein the short detecting unit is configured to determine that an internal short-circuit in the battery unit occurs, when a difference between a first voltage of the battery unit detected at a time a current flowing in the battery unit is below a predetermined current value and a second voltage of the battery unit detected at a time after a predetermined period has elapsed while the current flowing in the battery unit is below the predetermined current value is larger than a predetermined voltage difference value.

In an embodiment of the invention which solves or reduces one or more of the above-mentioned problems, the present disclosure provides a short detecting method for use in a battery pack including a battery unit containing a plurality of chargeable and dischargeable secondary batteries, the short detecting method comprising: detecting a current which flows in the battery unit; detecting a voltage of the battery unit; and detecting an internal short-circuit in the battery unit, wherein the detecting the internal short-circuit in the battery unit is configured to determine that an internal short-circuit in the battery unit occurs, when a difference between a first voltage of the battery unit detected at a time a current flowing in the battery unit is below a predetermined current value and a second voltage of the battery unit detected at a time after a predetermined period has elapsed while the current flowing in the battery unit is below the predetermined current value is larger than a predetermined voltage difference value.

In short, the battery pack of the embodiment of the invention is arranged to detect a first voltage of a battery unit containing a plurality of secondary batteries when charging and discharging of the battery unit is stopped, detect a second voltage of the battery unit when a predetermined period has elapsed after the time the charging and discharging of the battery unit is stopped, and determine whether an internal short-circuit occurs in the battery unit based on a voltage difference between the first voltage and the second voltage. The portable device of the embodiment of the invention is arranged to restrict operation of a main part of the portable device in response to a notice of internal short-circuit received from the battery pack.

According to the embodiments of the invention, it is possible to secure safety of a battery pack when short-circuit takes place inside a battery unit containing a plurality of secondary batteries.

Other objects, features and advantages of the invention will be apparent from the following detailed description when read in conjunction with the accompanying drawings.

### BRIEF DESCRIPTION OF THE DRAWINGS

FIG. 1 is a diagram showing the composition of a battery pack of a first embodiment of the invention.
FIG. 2 is a block diagram showing the hardware composition of a short detection IC of the first embodiment.
FIG. 3 is a block diagram showing the functional composition of the short detection IC of the first embodiment.
FIG. 4A, FIG. 4B and FIG. 4C are diagrams showing a current waveform and a voltage waveform at the time of charging the battery unit in the battery pack of the first embodiment.
FIG. 5A, FIG. 5B and FIG. 5C are diagrams showing a current waveform and a voltage waveform at the time of discharging the battery unit in the battery pack of the first embodiment.
FIG. 6 is a flowchart for explaining operation of the short detection IC of the first embodiment.
FIG. 7 is a diagram showing the composition of a portable device of an embodiment of the invention.
FIG. 8 is a block diagram showing the functional composition of a short detection IC in a battery pack of a second embodiment of the invention.
FIG. 9 is a flowchart for explaining operation of the short detection IC of the second embodiment.
FIG. 10 is a diagram for explaining a correction voltage value.
FIG. 11 is a block diagram showing the functional composition of a short detection IC in a battery pack of a third embodiment of the invention.
FIG. 12 is a flowchart for explaining operation of the short detection IC of the third embodiment.
FIG. 13 is a block diagram showing the composition of a battery pack according to the related art.

### DETAILED DESCRIPTION OF PREFERRED EMBODIMENTS

A description will now be given of embodiments of the invention with reference to the accompanying drawings.

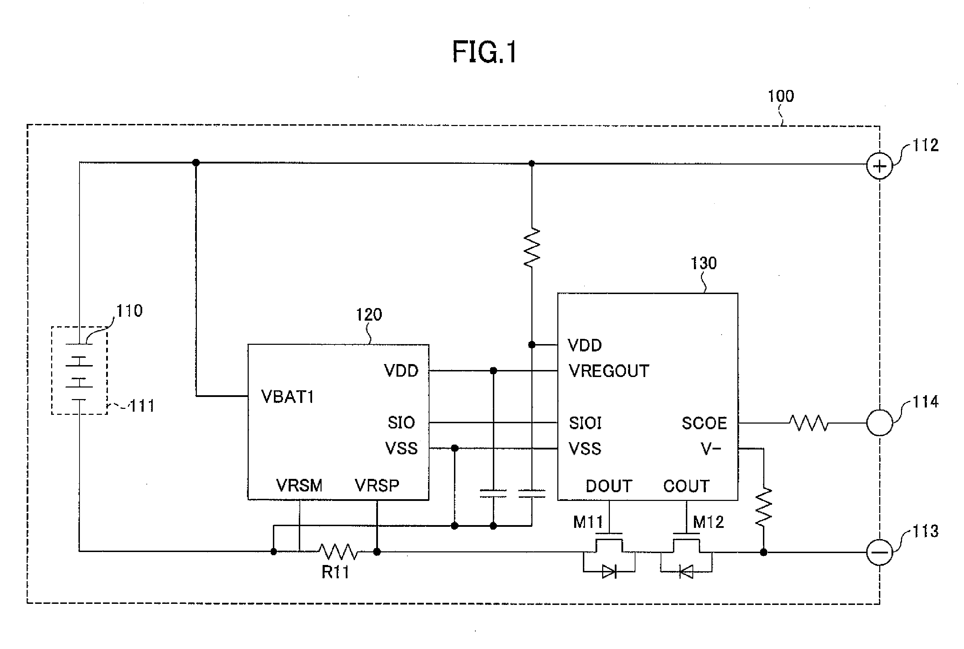

FIG. 1 is a diagram showing the composition of a battery pack 100 of a first embodiment of the invention.

As shown in FIG. 1, the battery pack 100 includes a battery unit 111 in which a plurality of secondary batteries 110, such as lithium ion batteries, are connected together. The battery unit 111 in this embodiment is arranged so that the secondary batteries 110 are connected in series. However, the present invention is not limited to this embodiment.

The battery pack 100 has a positive electrode terminal 112 and a negative electrode terminal 113 for connecting the battery pack 100 with a portable device (which will be described later) incorporating the battery pack 100 therein. The battery pack 100 includes a short detection IC 120 and a protection IC 130 which are arranged between the battery unit 111 and the positive and negative terminals 112, 113.

The short detection IC 120 has a power-source voltage terminal VDD, a reference voltage terminal VSS, a voltage detection terminal VBAT1, a pair of current detection terminals VRSP, VRSM, and a communication terminal SIO. The short detection IC 120 receives from the power-source voltage terminal VDD a voltage which is generated from the battery voltage regulated in the protection IC 130. The reference voltage terminal VSS of the short detection IC 120 is connected directly to the negative electrode of the battery unit 111.

The short detection IC 120 detects an internal short-circuit in the battery unit 111. Specifically, the short detection IC 120 detects an output voltage of the battery unit 111 from the voltage detection terminal VBAT1 which is connected to the positive electrode of the battery unit 111. The current detection terminal VRSM (one of the pair) is connected to the negative electrode of the battery unit 111, and connected further to the current detection terminal VRSP (the other of the pair) through a resistor R11 arranged outside the short detection IC 120.

Moreover, the short detection IC 120 detects a charging or discharging current of the battery unit 111 (i.e., a current which flows into the external resistor R11) through the current detection terminals VRSP and VRSM. The communication terminal SIO of the short detection IC 120 is connected through the protection IC 130 to an external terminal 114, and the external terminal 114 is used to allow the battery pack 100 to communicate with the portable device.

The short detection IC 120 communicates with the portable device through the communication terminal SIO and the protection IC 130.

The detailed composition of the short detection IC 120 will be described later.

The protection IC 130 has a terminal DOUT and a terminal COUT which are respectively connected to the gate of an n channel MOS transistor M11 and the gate of an n channel MOS transistor M12, and the MOS transistors M11 and M12 are arranged to intercept the charging and discharging of the battery pack 100.

When an overdischarge or overcurrent in the battery pack 100 is detected, the protection IC 130 sets the output signal DOUT to the low level to turn the MOS transistor M11 to an OFF state. When an overcharge in the battery pack 100 is detected, the protection IC 130 sets the output signal COUT to the low level to turn the MOS transistor M12 to the OFF state.

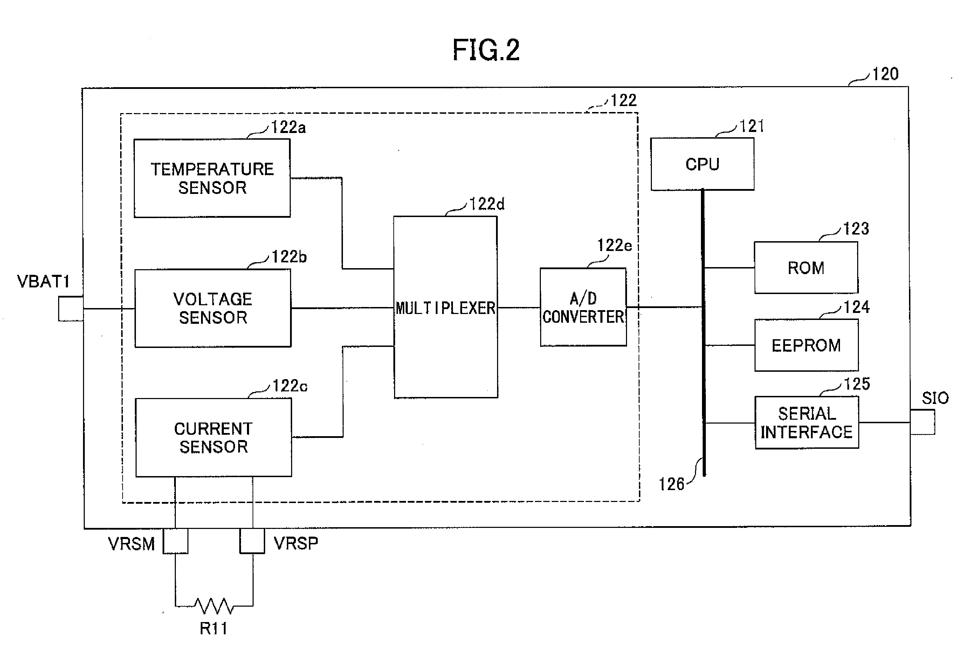

FIG. 2 is a diagram showing the hardware composition of the short detection IC 120 of the first embodiment.

As shown in FIG. 2, the short detection IC 120 of FIG. 2 includes a CPU (central processing unit) 121, a sensor unit 122, an ROM (read only memory) 123, an EEPROM (electrically erasable and programmable ROM) 124, and a serial interface (I/F) 125.

The CPU 121 controls the respective units of the short detection IC 120. The sensor unit 122 detects a voltage, a current, and a temperature of the battery unit 111 (see FIG. 1).

The ROM 123 stores a program which is executed by the CPU 121 to control the respective units of the short detection IC 120. The EEPROM 124 stores information indicating respective parameters including the voltage, the current, and the temperature of the battery unit 111 detected by the sensor unit 122, and information indicating an authentication ID for performing authentication between the battery pack and the portable device.

The serial interface 125 enables the short detection IC 120 to communicate with the portable device through the communication terminal SIO.

In the short detection IC 120, the CPU 121, the sensor unit 122, the ROM 123, the EEPROM 124, and the serial interface 125 are interconnected by a bus 126, and these elements can exchange the data and the program between them.

The sensor unit 122 includes a temperature sensor 122a, a voltage sensor 122b, a current sensor 122c, a multiplexer 122d, and an analog-to-digital (A/D) converter 122e.

The temperature sensor 122a detects a temperature of the battery unit 111. The voltage sensor 122b detects an output voltage of the battery unit 111 through the voltage detection terminal VBAT1 connected to the battery unit 111. The current sensor 122c detects a charging or discharging current of the battery unit 111 (i.e., a current which flows into the external resistor R11) through the current detection terminals VRSP and VRSM.

The respective outputs of the temperature sensor 122a, the voltage sensor 122b, and the current sensor 122c are connected to the multiplexer 122d, and the multiplexer 122d outputs an analog signal. The A/D converter 122e converts the analog signal output by the multiplexer 122d into a digital signal.

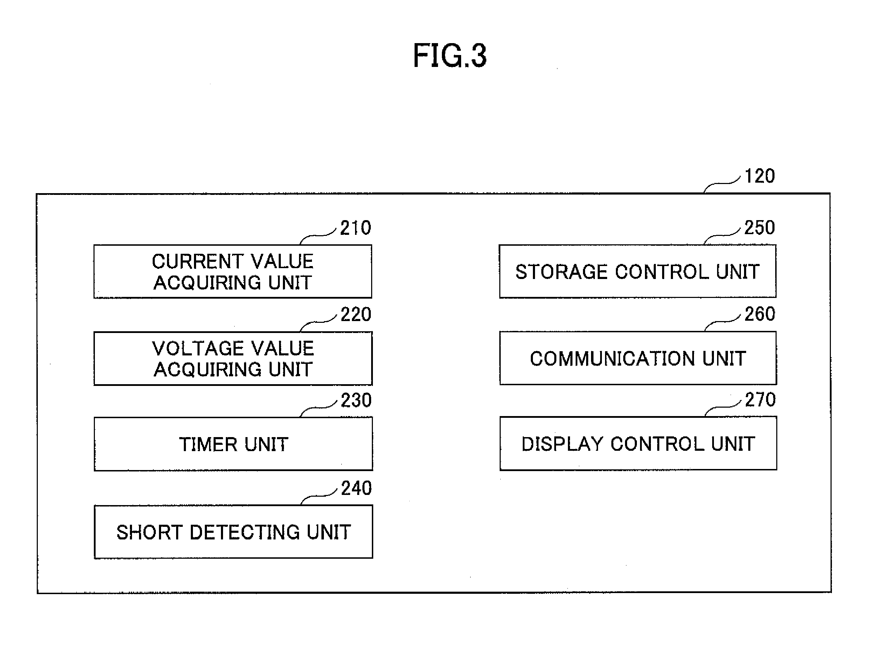

FIG. 3 is a block diagram showing the functional composition of the short detection IC 120 of the first embodiment.

In this embodiment, the functional composition of the short detection IC 120 shown in FIG. 3 is embodied by the program read from the ROM 123 shown in FIG. 2.

Alternatively, in another embodiment, the hardware module which embodies the functional composition of FIG. 3 may be arranged separately from the elements of the hardware composition of FIG. 2.

As shown in FIG. 3, the short detection IC 120 of the first embodiment includes a current value acquiring unit 210, a voltage value acquiring unit 220, a timer unit 230, a short detecting unit 240, a storage control unit 250, a communication unit 260, and a display control unit 270.

The current value acquiring unit 210 is configured to acquire a current value detected by the current sensor 122c. The voltage value acquiring unit 220 is configured to acquire a voltage value detected by the voltage sensor 122b.

The timer unit 230 is configured to measure a time by using the clock function provided in the short detection IC 120. The short detecting unit 240 is configured to detect an internal short-circuit in the battery unit 111, based on the current value acquired by the current value acquiring unit 210, the voltage value acquired by the voltage value acquiring unit 220, and the time measured by the timer unit 230.

The storage control unit 250 is configured to store, into the EEPROM 124, the parameters including the current value acquired by the current value acquiring unit 210 and the voltage value acquired by the voltage value acquiring unit 220. The communication unit 260 is configured to communicate with the portable device in which the battery pack 100 is provided. The display control unit 270 is configured to display a message indicating that an internal short-circuit occurs in the battery unit 111, when it is detected by the short detecting unit 240.

In the short detection IC 120 of this embodiment, when the current value acquired by the current value acquiring unit 210 is below a predetermined value, the storage control unit 250 is caused to store a corresponding first voltage value acquired by the voltage value acquiring unit 220 into the EEPROM 124. And after a predetermined period has elapsed while the state in which the acquired current value is below the predetermined value is continued, a second voltage value is acquired again by the voltage value acquiring unit 220. When a difference between the first voltage value previously stored in the EEPROM 124 and the second voltage value currently acquired by the voltage value acquiring unit 220 is above a predetermined value, it is determined that an internal short-circuit is occurring in the battery unit 111.

Before describing operation of the battery pack 100 of the first embodiment, the mechanism for internal short detection in the first embodiment will be now described.

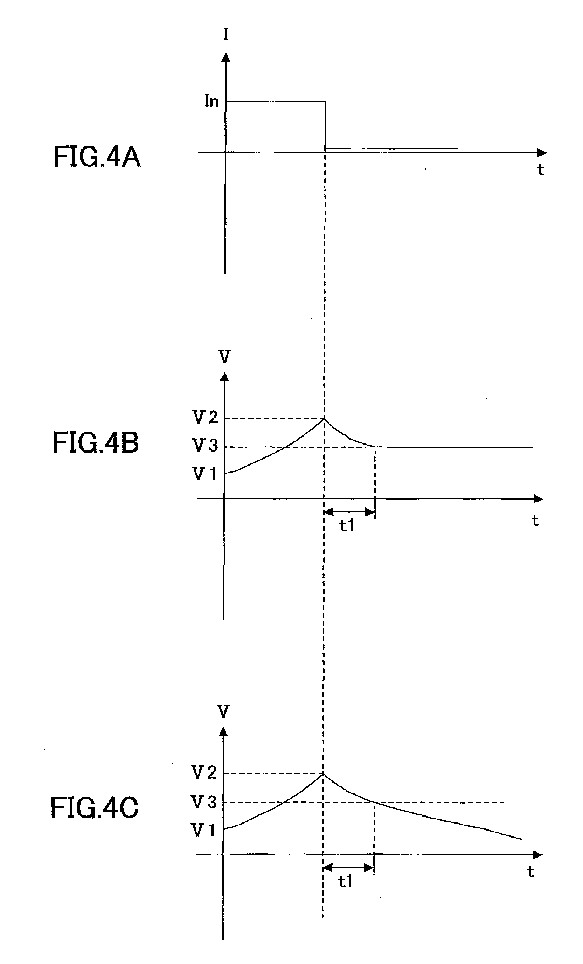

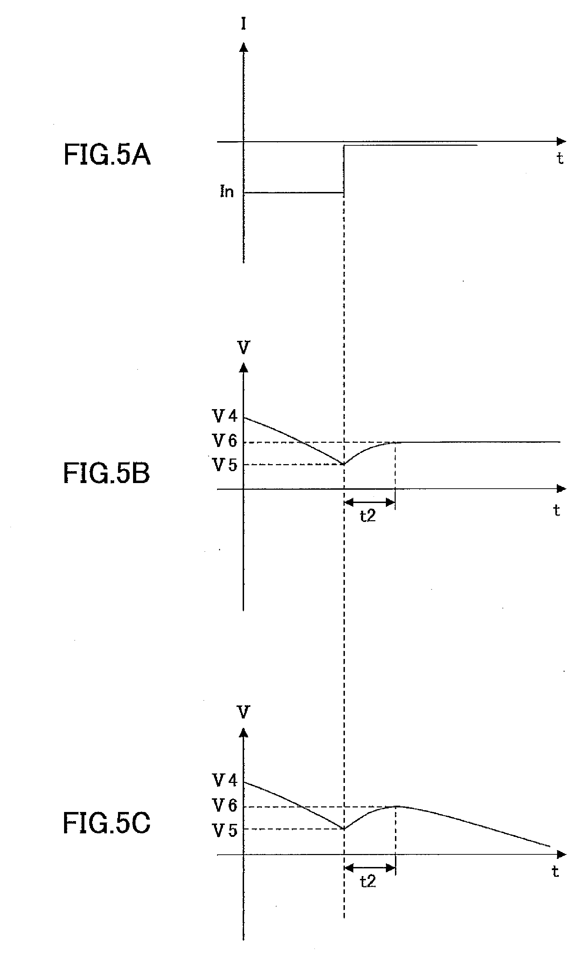

FIG. 4A, FIG. 4B and FIG. 4C are diagrams showing a current waveform and a voltage waveform at the time of charging the battery unit 111 in the battery pack 100. FIG. 5A, FIG. 5B and FIG. 5C are diagrams showing a current waveform and a voltage waveform at the time of discharging the battery unit 111 in the battery pack 100.

FIG. 4A shows a current waveform at the time of charging the battery unit 111, FIG. 4B shows a voltage waveform at the time of charging the battery unit 111 when no internal short-circuit occurs in the battery unit 111, and FIG. 4C shows a voltage waveform at the time of charging the battery unit 111 when an internal short-circuit occurs in the battery unit 111.

Normally, the battery unit 111 is charged by receiving the constant current In as shown in FIG. 4A, and the voltage of the battery unit 111 is gradually increased from a voltage value V1 to a voltage value V2. When the charging is stopped at the instant, the voltage value starts decreasing and, after a predetermined time t1 has elapsed, the voltage of the battery unit 111 is stabilized at an intermediate voltage value V3 (refer to FIG. 4B).

However, if an internal short-circuit takes place in the battery unit 111, even when the time t1 has elapsed after the charging is stopped, the voltage value continuously decreases without being stabilized at the voltage value V3 (refer to FIG. 4C).

Therefore, when the voltage value continuously decreases even if the time t1 has elapsed after the charging is stopped, it can be determined that an internal short-circuit occurs in the battery unit 111.

Next, FIG. 5A shows a current waveform at the time of discharging the battery unit 111, FIG. 5B shows a voltage waveform at the time of discharging the battery unit 111 when no internal short-circuit occurs in the battery unit 111, and FIG. 5C shows a voltage waveform at the time of discharging the battery unit 111 when an internal short-circuit occurs in the battery unit 111.

Normally, the battery unit 111 is discharged by outputting the constant current In as shown in FIG. 5A, and the voltage of the battery unit 111 is gradually decreased from a voltage value V4 to a voltage value V5. When the discharging is stopped at the instant, the voltage value starts increasing and, after a predetermined time t2 has elapsed, the voltage of the battery unit 111 is stabilized at an intermediate voltage value V6 (refer to FIG. 5B).

However, if an internal short-circuit takes place in the battery unit 111, even when the time t2 has elapsed after the discharging is stopped, the voltage value continuously decreases without being stabilized at the voltage value V6 (refer to FIG. 5C).

Therefore, when the voltage value continuously decreases even if the time t2 has elapsed after the discharging is stopped, it can be determined that an internal short-circuit occurs in the battery unit 111.

Accordingly, in the short detection IC 120 of the first embodiment, the occurrence of an internal short-circuit in the battery unit 111 is detected by making use of the characteristics of the battery unit 111 described above with FIGs. 4A to 5C.

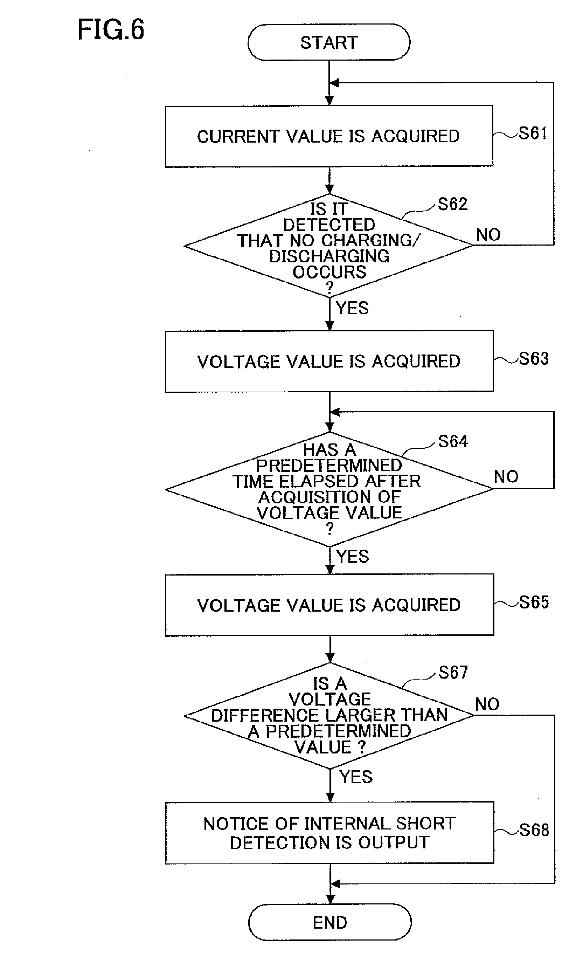

Next, FIG. 6 is a flowchart for explaining operation of the short detection IC 120 of the first embodiment.

Upon start of the operation shown in FIG. 6, the short detection IC 120 causes the current value acquiring unit 210 to acquire a current value detected by the current sensor 122c (S61). The short detecting unit 240 determines whether charging or discharging of the battery unit 111 is performed, based on the current value acquired in step S61.

Specifically, the short detecting unit 240 compares the current value acquired in step S61 with a predetermined current value which is stored beforehand in the ROM 123. When the current value acquired in step S61 is below the predetermined current value, it is determined that charging or discharging of the battery unit 111 is not performed. The predetermined current value is a value used for detecting the state in which charging or discharging of the battery unit 111 is stopped. Therefore, it is preferred that the predetermined current value is sufficiently smaller than a current value when charging or discharging of the battery unit 111 is performed.

Because a standby current flows in the battery pack 100 even when charging or discharging is not performed, it is preferred that the predetermined current value is distinct from the standby current.

For example, the standby current which flows in the battery pack 100 in this embodiment when it is arranged in a portable device is about 1 mA. Therefore, the predetermined current value may be set to about 10 mA. The standby current means the current which flows in a waiting state of the portable device in a case in which the portable device is a cellular phone.

When the current value acquired in step S61 is smaller than the predetermined current value, the short detecting unit 240 determines that charging or discharging is not performed (S62). At this time, the short detection IC 120 causes the voltage value acquiring unit 220 to acquire a voltage value Va detected by the voltage sensor 122b (S63).

The short detection IC 120 causes the storage control unit 250 to store the acquired voltage value Va and time information indicating the time the voltage value Va is acquired, into the EEPROM 124, for example. The time information is acquired by using the clock function provided in the short detection IC 120.

Next, the short detecting unit 240 determines whether a predetermined period has elapsed after the acquisition of the voltage value Va in step S63 (S64). Specifically, the short detecting unit 240 compares a period from the instant the voltage value Va is stored in the EEPROM 124 to the instant the subsequently elapsed time is measured by the timer unit 230, with the predetermined period. The predetermined period may be set to either the time t1 in FIG. 4B or the time t2 in FIG. 5B. The predetermined period indicates the period from the instant charging or discharging of the battery unit 111 is stopped to the instant the voltage value is stabilized when no internal short-circuit occurs in the battery unit 111.

The predetermined time may be set to the longer one of the time t1 and the time t2. For example, the predetermined period may be stored beforehand in the ROM 123. The predetermined period in this embodiment may be set to, for example, 5 hours.

When it is determined in step S64 that the predetermined period has elapsed, the short detection IC 120 causes the voltage value acquiring unit 220 to acquire again a voltage value Vb detected by the voltage sensor 122b (S65). The short detecting unit 240 compares the voltage value Va acquired in step S63 and the voltage value Vb acquired in step S65, and determines whether a difference between the voltage value Va and the voltage value Vb is larger than a predetermined value (S67).

The predetermined value is a reference value used for determining that the voltage value is not yet stabilized. The predetermined value may be stored in the ROM 123 beforehand. The predetermined value may be set to the value indicating (V2-V3) in the example of FIGs. 4A to 4C or set to the value indicating (V6-V5) in the example of FIGs. 5A to 5C.

When it is determined in step S67 that the difference between the voltage value Va and the voltage value Vb is larger than the predetermined value, the short detecting unit 240 determines that an internal short-circuit occurs in the battery unit 111. In this case, the short detecting unit 240 notifies the communication unit 260 of the occurrence of an internal short-circuit in the battery unit 111. The communication unit 260 outputs a notice of internal short detection to the portable device (S68).

Specifically, the notice of internal short detection is transmitted from the communication terminal SIO of the short detection IC 120 to the portable device via the protection IC 130.

Alternatively, the above embodiment may be arranged so that, when an internal short-circuit is detected, the display control unit 270 displays a message indicating the detection of the internal short-circuit. For example, the display control unit 270 may cause the LED (light-emitting diode) in the battery pack 100 to be turned ON, indicating that an internal short-circuit in the battery unit 111 is detected.

In this embodiment, an internal short-circuit in the battery unit 111 can be detected as described above.

Next, the portable device of an embodiment of the invention will be described.

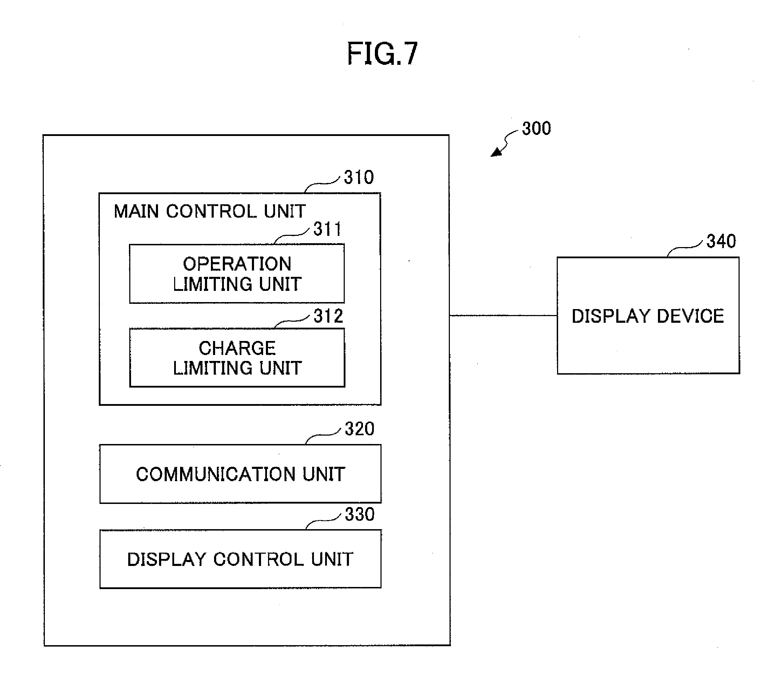

FIG. 7 is a diagram showing the composition of a portable device 300 of an embodiment of the invention.

In the portable device 300 of this embodiment, the battery pack 100 shown in FIG. 1 is arranged, and, when an internal short-circuit in the battery unit 111 is detected by the battery pack 100, the battery pack 100 outputs a notice of internal short detection to the portable device 300, and operation of the main part of the portable device 300 can be controlled in response to this notice.

Examples of the portable device 300 are a cellular phone, a digital camera, etc. Namely, the portable device 300 is an electronic device which is driven by electric power supplied by the battery pack 100.

If an internal short-circuit in the battery unit 111 is detected by the battery pack 100, the portable device 300 restricts operation of the portable device 300. If an internal short-circuit in the battery unit 111 is detected, the portable device 300 can restrict the charging operation to the battery pack 100.

The portable device 300 includes a processing unit and a storage device (which are not shown in FIG. 7), and the functions of respective units of the portable device 300 (which will be explained below) are carried out by causing the processing unit to execute a specific program read from the storage device.

As shown in FIG. 7, the portable device 300 includes a main control unit 310, a communication unit 320, and a display control unit 330.

The main control unit 310 controls operation of the portable device 300. The main control unit 310 includes an operation limiting unit 311 and a charge limiting unit 312. The operation limiting unit 311 restricts operation of the portable device 300 in response to a notice of internal short detection from the battery pack 100. The charge limiting unit 312 restricts the charging operation to the battery pack 100 in response to a notice of internal short detection from the battery pack 100.

The communication unit 320 performs communication with the battery pack 100. Specifically, the communication unit 320 is connected to the battery pack 100 and performs communication with the short detection IC 120 via the protection IC 130 provided in the battery pack 100.

The display control unit 330 controls the displaying of messages or operational indications on a display device 340 which is provided in the portable device 300. For example, the display device 340 is a liquid crystal display device provided in the portable device 300.

In the portable device 300 of this embodiment, if a notice of internal short detection of the battery unit 111 is received via the communication unit 320, the main control unit 310 performs the operation restriction or charging operation of the portable device 300. In this embodiment, the setting data relating to the operation restriction and charging restriction of the portable device 300 is stored beforehand in the storage device (which is not illustrated). The main control unit 310 reads out the setting data in response to the notice of internal short detection, and performs the operation restriction or charging restriction of the portable device 300.

For example, the main control unit 310 may cause the operation limiting unit 311 to intercept the power supply of the portable device 300 in response to a notice of internal short detection. The main control unit 310 may cause the operation limiting unit 311 to inhibit operation of the operation button (not shown) provided in the portable device 300. The main control unit 310 may cause the charge limiting unit 312 to stop the charging of the battery pack 100.

In the portable device 300, the display control unit 330 displays a message indicating that an internal short-circuit in the battery unit 111 is detected on the display device 340 in response to a notice of internal short detection. At this time, the display control unit 330 may further display a message indicating that operation and charging of the portable device 300 are restricted. These messages may be stored beforehand in the storage device which is not illustrated.

Thus, in this embodiment, the user of the portable device 300 is notified that an internal short-circuit in the battery unit 111 is detected, and operation of the portable device 300 is restricted in such a case. It is possible to prevent the battery pack 100 in which the internal short-circuit in the battery unit 111 takes place from being continuously used. Therefore, according to this embodiment, it is possible to secure safety when an internal short-circuit in the battery unit 111 occurs.

Next, a second embodiment of the invention will be described. The second embodiment differs from the first embodiment in that an internal short-circuit in a battery unit is detected in the second embodiment by using an available capacity value of the battery unit. For the sake of convenience, only the features of the second embodiment differing from the first embodiment will be described. In the following, the elements in the second embodiment which are the same as corresponding elements in the first embodiment are designated by the same reference numerals, and a description thereof will be omitted.

The amount of discharge from the battery unit 111 varies depending on the battery voltage. A change in the amount of discharge is not proportional to a change in the battery voltage. Taking into consideration this point, the battery pack of this embodiment is arranged to detect an internal short-circuit in the battery unit 111 by using an available capacity value of the battery unit 111, which makes it possible to detect more accurately an internal short-circuit in the battery unit.

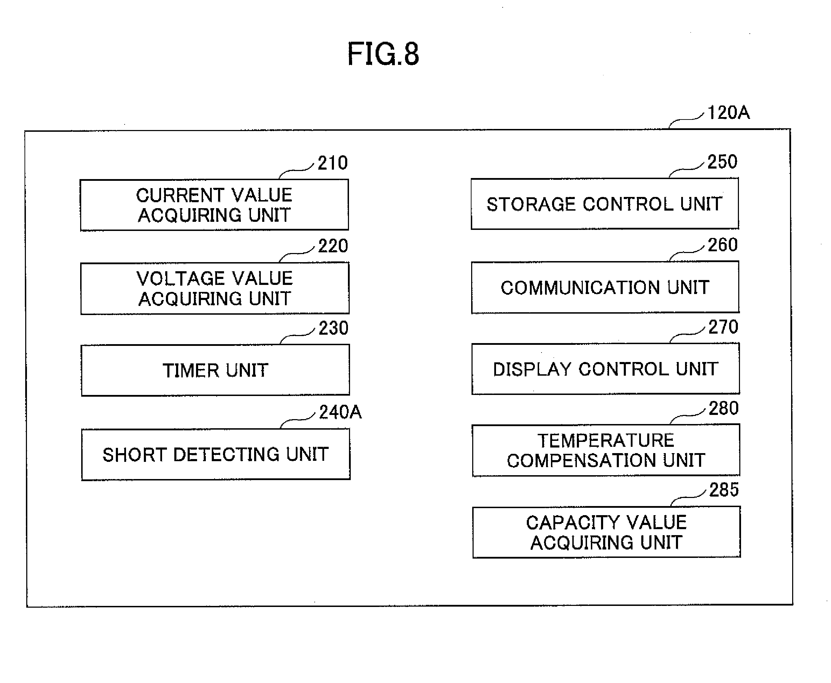

FIG. 8 is a block diagram showing the functional composition of a short detection IC 120A of the second embodiment.

In addition to the respective units of the short detection IC 120 of the first embodiment, the short detection IC 120A of the second embodiment further includes a temperature compensation unit 280 and a capacity value acquiring unit 285.

The short detecting unit 240A of this embodiment is configured to detect an internal short-circuit in the battery unit 111 based on an available capacity value acquired by the capacity value acquiring unit 285 and a time measured by the timer unit 230.

The temperature compensation unit 280 is configured to correct a voltage value acquired by the voltage value acquiring unit 220 based on a temperature detected by the temperature sensor 122a. In this embodiment, when the voltage value acquiring unit 220 acquires a voltage value detected by the voltage sensor 122b, the temperature compensation unit 280 acquires a temperature of the battery unit 111 detected by the temperature sensor 122a. At the same time, the capacity value acquiring unit 185 acquires a value of an available capacity of the battery unit 111.

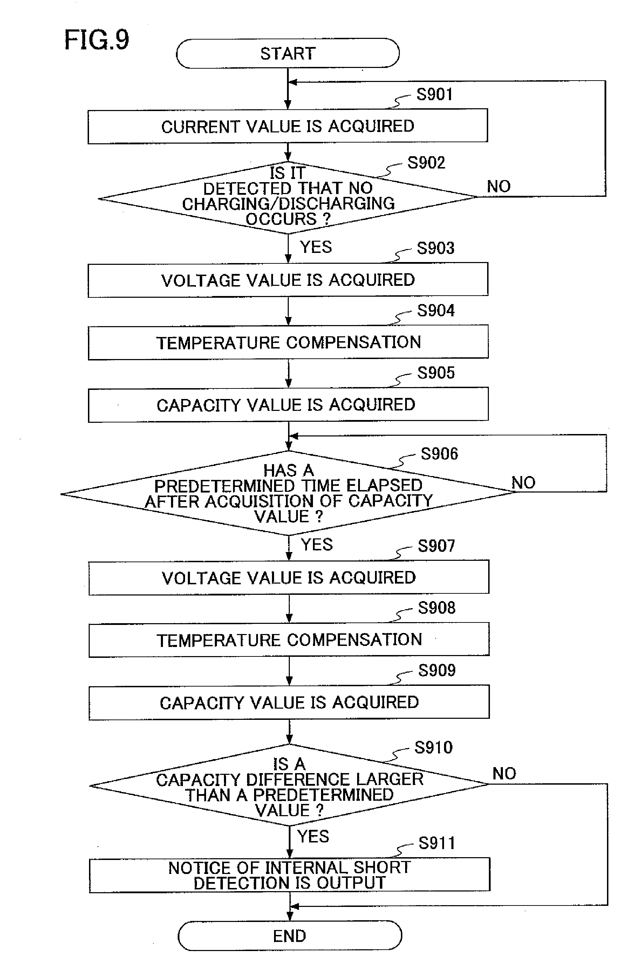

Next, operation of the short detection IC 120A of this embodiment will be described. FIG. 9 is a flowchart explaining operation of the short detection IC 120A of the second embodiment.

In the operation shown in FIG. 9, steps S901 to S903 are the same as the steps S61 to S63 in FIG. 6, and a description thereof will be omitted.

After a voltage value is acquired by the voltage value acquiring unit 220 in step S903, the temperature compensation unit 280 performs temperature compensation of the acquired voltage value (S904). The temperature compensation of this embodiment will be described below.

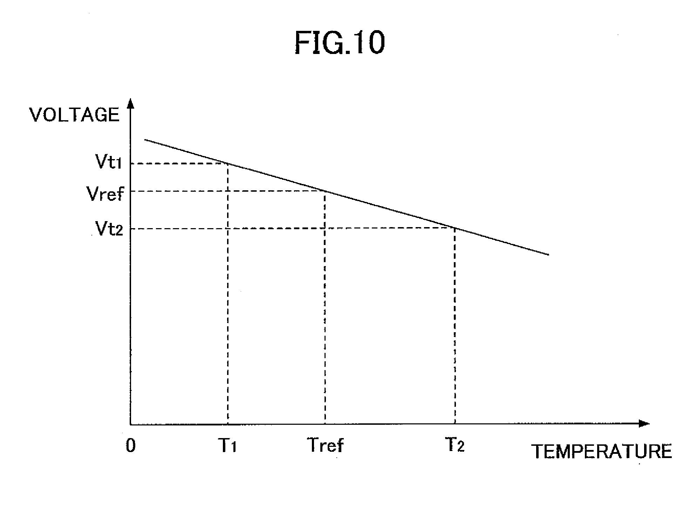

In the short detection IC 120A of this embodiment, a compensation table for correcting a voltage value is stored. This compensation table is a table in which a correction voltage value for every temperature change which is determined according to the relationship between the battery voltage (voltage value) and the temperature is stored. This correction voltage value will now be described with reference to FIG. 10. FIG. 10 is a diagram explaining a correction voltage value.

The relationship between the battery voltage and the temperature is approximately proportional as shown in FIG. 10. Suppose that a voltage value at a reference temperature Tref is a reference voltage Vref. In this embodiment, a correction voltage value is defined as being a change in the voltage value corresponding to a difference between the reference temperature Tref and a temperature of the battery unit 111 detected when the voltage value is acquired.

For example, if a voltage value acquired at a temperature T1 is indicated by Vt1, the correction voltage value is a change in the voltage value corresponding to a difference (Tref-T1) between the reference temperature Tref and the temperature T1, which is indicated by (Vref-Vt1). If a voltage value acquired at a temperature T2 is indicated by Vt2, the correction voltage value is a change in the voltage value corresponding to a difference (Tref-T2) between the reference temperature Tref and the temperature T2, which is indicated by (Vref-Vt2).

In the compensation table of this embodiment, a difference between the reference temperature and a temperature when a voltage value is detected is associated with the corresponding correction voltage value. The reference temperature Tref and the compensation table are stored beforehand in the EEPROM 124 provided in the short detection IC 120A.

The temperature compensation unit 280 of this embodiment computes a difference between the reference temperature and a temperature detected when the voltage value is acquired in step S903, and acquires a correction voltage value by making reference to the compensation table. Then, the temperature compensation unit 280 converts the acquired voltage value into a voltage value at the reference temperature Tref by using the correction voltage value.

Referring back to FIG. 9, after the temperature compensation of the acquired voltage value is performed in step S904, the short detection IC 120A causes the capacity value acquiring unit 285 to acquire an available capacity value Q1 of the battery unit 111 (S905).

Next, the processing performed by the capacity value acquiring unit 285 will be described. An available capacity value table in which voltage values and available capacity values are associated with each other is stored beforehand in the EEPROM 124 of the short detection IC 120A of this embodiment.

In step S905, the capacity value acquiring unit 285 makes reference to the available capacity value table based on the voltage value obtained by the temperature compensation in step S904, and acquires a corresponding available capacity value Q1 from the available capacity value table. The acquired available capacity value Q1 is stored in the EEPROM 124.

Next, the short detecting unit 240A determines whether a predetermined period has elapsed after the acquisition of the available capacity value Q1 in step S905 (S906). Specifically, the short detecting unit 240A compares a period from the instant the available capacity value Q1 is stored in the EEPROM 124 to the instant the subsequently elapsed time is measured by the timer unit 230, with the predetermined period. The predetermined period in this embodiment may be set to, for example, 1 hour. It is preferred that the predetermined period in this embodiment is shorter than that in the previously described embodiment of FIG. 6. For example, the predetermined time in this embodiment may be stored beforehand in the ROM 123.

When it is determined in step S906 that the predetermined period has elapsed, the short detection IC 120A causes the voltage value acquiring unit 220 to acquire again a voltage value detected by the voltage sensor 122b (S907). The temperature compensation unit 280 performs temperature compensation of the voltage value acquired in step S907 (S908). The method of temperature compensation in step S908 is the same as described above in the step S904.

The capacity value acquiring unit 285 computes an available capacity value Q2 of the battery unit 111 when the predetermined period has elapsed after the temperature compensation of the voltage value is performed (S909). Specifically, the capacity value acquiring unit 285 makes reference to the available capacity value table based on the temperature-compensated voltage value and acquires a corresponding available capacity value Q2 from the available capacity value table.

Next, the capacity value acquiring unit 285 computes a difference between the available capacity value Q1 acquired in step S905 and the available capacity value Q2.

Next, the capacity value acquiring unit 285 computes a discharge capacity value Qdis due to the current which has flowed during the time (the predetermined period) that has elapsed after the acquisition of the available capacity value Q1. The current having flowed during the predetermined period is represented by the current value detected in step S901. And the capacity value acquiring unit 285 acquires a self-discharge capacity value Qsd of the battery unit 111 and the short detection IC 120A. This self-discharge capacity value Qsd is stored beforehand in the ROM 123, for example.

Next, the capacity value computing unit 285 computes a capacity value Qus by subtracting the discharge capacity value Qdis and the self-electric discharge capacity value Qsd from the difference between the available capacity value Q1 and the available capacity value Q2. This capacity value Qus indicates a capacity difference, or a change in the available capacity value of the battery unit 111 during the predetermined period. Specifically, the capacity value Qus is represented by the formula: Qus = Q1 - Q2 - Qdis - Qsd. The short detecting unit 240A determines whether the capacity value Qus is larger than a predetermined value (S910).

When it is determined in step S910 that the capacity value Qus is larger than the predetermined value, the short detecting unit 240A determines that an internal short-circuit in the battery unit 111 takes place. In this case, the short detecting unit 240A notifies the communication unit 260 of the occurrence of an internal short-circuit in the battery unit 111. The communication unit 260 outputs a notice of internal short detection to the portable device (S911).

Specifically, the notice of internal short detection is transmitted from the communication terminal SIO of the short detection IC 120A to the portable device via the protection IC 130. It is assumed that the predetermined value in step S910, which is a reference capacity value for the internal short detection, is stored beforehand in the ROM 123.

Usually, if an internal short-circuit in the battery unit 111 takes place, the discharge capacity value increases as the time passes. According to the second embodiment, the detection of an internal short-circuit in the battery unit 111 can be performed accurately and the safety during use of the battery pack 100 can be improved further.

Next, a third embodiment of the invention will be described. The third embodiment differs from the second embodiment in that an internal short-circuit in a battery unit is detected in the third embodiment by using a current value computed from a discharge capacity of the battery unit. For the sake of convenience, only the features of the third embodiment differing from the second embodiment will be described. In the following, the elements in the third embodiment which the same as corresponding elements in the second embodiment are designated by the same reference numerals, and a description thereof will be omitted.

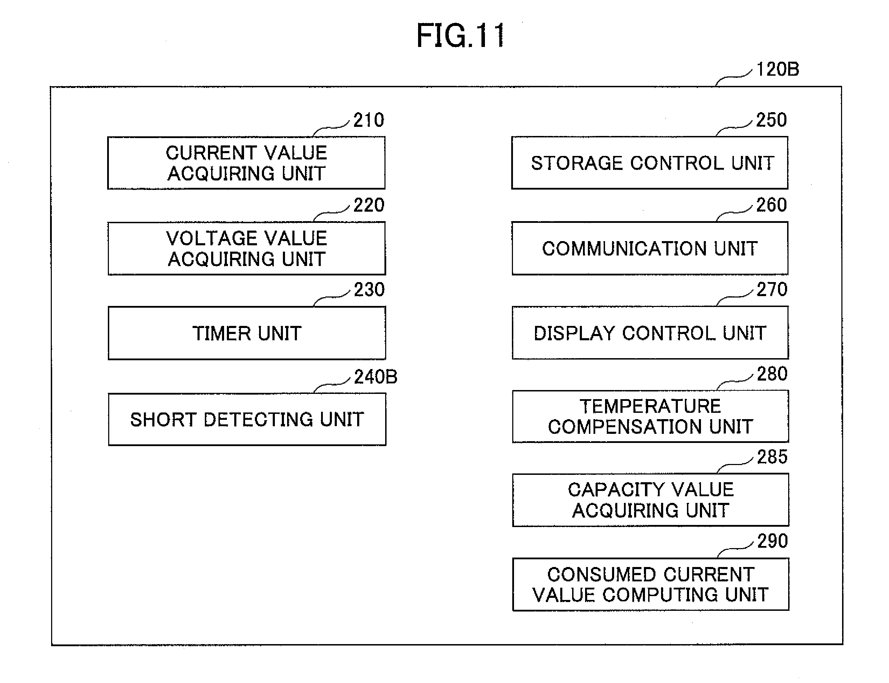

FIG. 11 is a block diagram showing the functional composition of a short detection IC 120B of the third embodiment.

In addition to the respective units of the short detection IC 120A of the second embodiment, the short detection IC 120B of this embodiment further includes a consumed current value computing unit 290.

The short detecting unit 240B of this embodiment is arranged to detect an internal short-circuit in the battery unit 111 based on a current value computed from a discharge capacity value.

The consumed current value computing unit 290 computes a consumed current value based on a capacity value acquired by the capacity value acquiring unit 285.

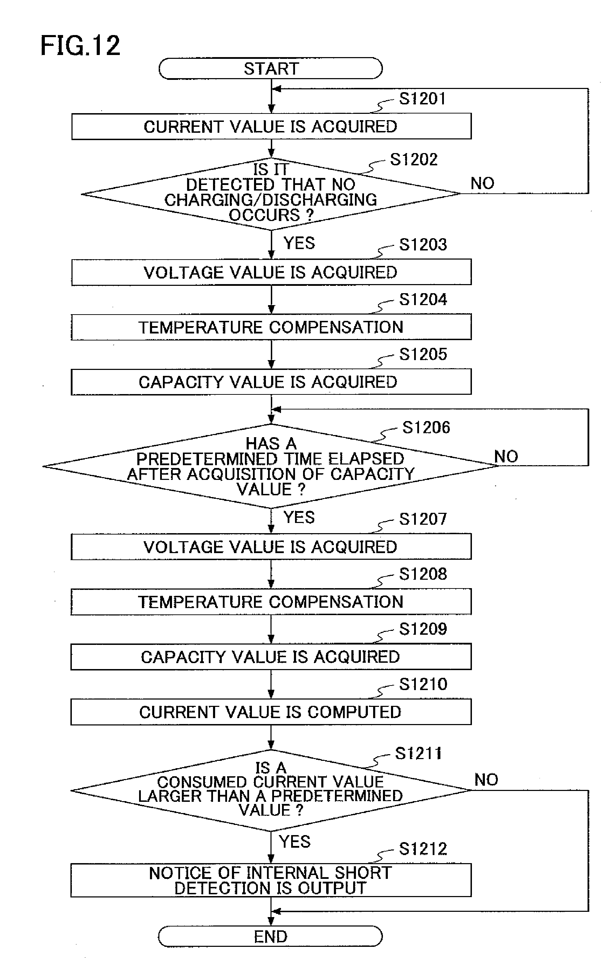

Next, operation of the short detection IC 120B of this embodiment will be described. FIG. 12 is a flowchart for explaining operation of the short detection IC 120B of the third embodiment.

In the operation shown in FIG. 12, steps S1201 to S1209 are the same as the steps S901 to S909 shown in FIG. 9, and a description thereof will be omitted.

After the capacity value Qus which indicate the discharge capacity value for the predetermined period is acquired in step S1209, the current value computing unit 290 computes a consumed current value Ius during the predetermined period by using the capacity value Qus (S1210).

Specifically, the current value computing unit 290 computes a consumed current value Ius by the formula: Ius = (Q2 - Q1)/td - (Idis + Isd)
where td indicates the predetermined period, Idis indicates an integrated value of the current detected for the predetermined period td, and Isd indicates a self-discharge current value of the battery unit 111 and the short detection IC 120B.

Next, the short detecting unit 240B determines whether the consumed current value Ius is larger than a predetermined value (S1211). When it is determined in step S1211 that the consumed current value Ius is larger than the predetermined value, the short detecting unit 240B determines that an internal short-circuit in the battery unit 111 takes place. In this case, the short detecting unit 240B notifies the communication unit 260 of the occurrence of an internal short-circuit in the battery unit 111. The communication unit 260 outputs a notice of internal short detection to the portable device (S1212).

It is assumed that the predetermined value in step S1211 which is a reference consumed current value used for internal short detection is stored beforehand in the ROM 123.

In this embodiment, a consumed current value is computed based on the discharge capacity value during the predetermined period, and the detection of an internal short-circuit in the battery unit can be detected. In this embodiment, the detection of an internal short-circuit is based on the discharge capacity value, and it is possible to detect an internal short-circuit in the battery unit more accurately.

The present invention is not limited to the above-described embodiments, and variations and modifications may be made without departing from the scope of the invention.

## Claims

1. A battery pack (100) including a battery unit (111) containing a plurality of chargeable and dischargeable secondary batteries (110), comprising:
a current detecting unit (122c) configured to detect a current which flows in the battery unit (111);
a voltage detecting unit (122b) configured to detect a voltage of the battery unit (111); and
a short detecting unit (240) configured to detect an internal short-circuit in the battery unit (111),
wherein the short detecting unit (240) is configured to determine that an internal short-circuit in the battery unit (111) occurs, when a difference between a first voltage of the battery unit (111) detected at a time a current flowing in the battery unit (111) is below a predetermined current value and a second voltage of the battery unit (111) detected at a time after a predetermined period has elapsed while the current flowing in the battery unit (111) is below the predetermined current value is larger than a predetermined voltage difference value.

2. The battery pack (100) according to claim 1, further comprising a capacity value acquiring unit (285) configured to acquire an available capacity value of the battery unit (111), based on a voltage detected by the voltage detecting unit (122b),
wherein the short detecting unit (240A) is configured to determine that an internal short-circuit in the battery unit (111) occurs, when a difference between a first available capacity value of the battery unit (111) acquired at a time a current flowing in the battery unit (111) is below the predetermined current value and a second available capacity value of the battery unit (111) acquired at a time after a predetermined period has elapsed while the current flowing in the battery unit (111) is below the predetermined current value is larger than a predetermined value.

3. The battery pack (100) according to claim 2, further comprising:
a temperature detecting unit (122a) configured to detect a temperature of the battery unit (111); and
a temperature compensation unit (280) configured to correct a voltage detected by the voltage detecting unit (122b) based on a temperature detected by the temperature detecting unit (122a),
wherein the capacity value acquiring unit (285) is configured to acquire an available capacity value of the battery unit (111) based on the voltage corrected by the temperature compensation unit (280).

4. The battery pack (100) according to claim 3, further comprising a current value computing unit (290) configured to compute a value of a current consumed during a predetermined period, based on a difference between a first available capacity value of the battery unit (111) acquired at a time a current flowing in the battery unit (111) is below the predetermined current value and a second available capacity value of the battery unit (111) acquired at a time after the predetermined period has elapsed while the current flowing in the battery unit (111) is below the predetermined current value,
wherein the short detecting unit (240B) is configured to determine that an internal short-circuit in the battery unit (111) occurs, when the value of the current computed by the current value computing unit (290) is larger than a reference value.

5. The battery pack (100) according to any of claims 1 to 4, further comprising a communication unit (260) configured to communicate with a portable device (300) in which the battery pack (100) is arranged, wherein the communication unit (260) outputs a notice of internal short detection to the portable device when it is determined by the short detecting unit (240) that an internal short-circuit in the battery unit (111) occurs.

6. A portable device (300) in which the battery pack (100) according to claim 1 is arranged.

7. The portable device (300) according to claim 6, wherein the battery pack (100) comprises a communication unit (260) configured to output a notice of internal short detection to the portable device (300) when it is determined by the short detecting unit (240) that an internal short-circuit in the battery unit (111) occurs, and
the portable device (300) is configured to restrict operation of the portable device (300) in response to a notice of internal short detection from the communication unit (260).

8. The portable device (300) according to claim 7, wherein the portable device (300) is configured to restrict charging of the battery pack (100) in response to a notice of internal short detection from the communication unit (260).

9. The portable device (300) according to claim 7 or 8, wherein the portable device (300) is configured to intercept power supply to the portable device in response to a notice of internal short detection from the communication unit.

10. A short detecting method for use in a battery pack (100) including a battery unit (111) containing a plurality of chargeable and dischargeable secondary batteries (110), the short detecting method comprising:
detecting a current which flows in the battery unit (111);
detecting a voltage of the battery unit (111); and
detecting an internal short-circuit in the battery unit (111),
wherein the detecting the internal short-circuit in the battery unit (111) is configured to determine that an internal short-circuit in the battery unit (111) occurs, when a difference between a first voltage of the battery unit (111) detected at a time a current flowing in the battery unit (111) is below a predetermined current value and a second voltage of the battery unit (111) detected at a time after a predetermined period has elapsed while the current flowing in the battery unit (111) is below the predetermined current value is larger than a predetermined voltage difference value.

11. A computer-readable recording medium storing a program which, when executed by a processing unit (121) of a battery pack (100) including a battery unit (111) containing a plurality of chargeable and dischargeable secondary batteries (110), causes the processing unit (121) to perform a short detecting method comprising:
detecting a current which flows in the battery unit (111);
detecting a voltage of the battery unit (111); and
detecting an internal short-circuit in the battery unit (111),
wherein the detecting the internal short-circuit in the battery unit (111) is configured to determine that an internal short-circuit in the battery unit (111) occurs, when a difference between a first voltage of the battery unit (111) detected at a time a current flowing in the battery unit (111) is below a predetermined current value and a second voltage of the battery unit (111) detected at a time after a predetermined period has elapsed while the current flowing in the battery unit (111) is below the predetermined current value is larger than a predetermined voltage difference value.
